Europäisches Patentamt

European Patent Office

Office européen des brevets

(11) Veröffentlichungsnummer: **0 339 132**
A2

# (12) EUROPÄISCHE PATENTANMELDUNG

(21) Anmeldenummer: 88119651.3

(22) Anmeldetag: 25.11.88

(51) Int. Cl.⁴ **C23C 14/56 , H01L 21/00 , B65G 47/51**

(30) Priorität: 24.02.88 CH 686/88

(43) Veröffentlichungstag der Anmeldung:
02.11.89 Patentblatt 89/44

(84) Benannte Vertragsstaaten:
CH DE FR GB IT LI NL SE

(71) Anmelder: **BALZERS AKTIENGESELLSCHAFT**

**FL-9496 Balzers(LI)**

(72) Erfinder: **Schertler, Roman**
**Schertlerstrasse 18**
**A-6922 Wolfurt(AT)**

(54) Vorrichtung zum Speichern von Objekten unter Vakuum.

(57) Die Vorrichtung zum Speichern von Objekten unter Vakuum weist in einer evakuierbaren Kammer eine drehbare Haltevorrichtung für die Objekte auf, die vorzugsweise als Hohltrommel (3) mit axialer Nabe (2) ausgebildet ist, wobei zur Halterung für die Objekte (4, 4', 4") die Innenseite des Trommelmantels und die Aussenseite der Nabe achsenparallele Nuten (5 bzw. 6) besitzen und in jedes Nutenpaar mindestens zwei Objekte in achsenparalleler Richtung eingeschoben werden können. In der Kammer kann zusätzlich eine Hilfseinrichtung zur Behandlung der Objekte z.B. eine Heizvorrichtung vorgesehen werden.

EP 0 339 132 A2

## Vorrichtung zum Speichern von Objekten unter Vakuum

Die Erfindung betrifft eine Vorrichtung zum Speichern von Objekten unter Vakuum; gleichzeitig kann sie auch als Vakuumschleuse verwendet werden.

Schleusen zum Ein- und Ausbringen von Objekten in bzw. aus Vakuumkammern, in denen sie einer Behandlung unterworfen werden, sind seit langem bekannt. Die Funktion solcher Schleusen besteht meist darin, Objekte, die sich zunächst ausserhalb der Vakuumbehandlungskammer in einer Atmosphäre höheren Drucks - häufig unter atmosphärischem Luftdruck -befinden, in die evakuierte Behandlungskammer hinein und nach der Behandlung wieder herauszubringen, ohne dass das Vakuum unterbrochen werden muss. Vakuumschleusen sind in zahlreichen Varianten bekannt geworden u.a.auch als sogenannte Durchlaufschleusen, bei denen die Objekte mittels einer Transporteinrichtung - oft über mehrere Druckstufen hinweg - in die Kammer hinein und dann wieder herausbewegt werden können. Eine Schleuse dieser Art ist z.B. in der britischen Patentschrift 515 148 beschrieben. Eine weitere ähnliche Vorrichtung ist aus US-PS 3 486 365 ersichtlich. Dort werden für die einzuschleusenden Objekte (z.B.Transistoren) als Träger zylindrische Behälter benutzt, die mittels Ringdichtungen gegenüber der Wand des Schleusenkanals abgedichtet werden. Eine spezielle Ausführungsform zeigt die Fig. 6 der genannten Patentschrift, bei der zusätzlich zur Druckstufenanordnung noch eine weitere zylindrische Kammer mit darin angeordnetem Drehtisch vorgesehen ist, wobei der Drehtisch eine Mehrzahl von kreisförmig angeordneten Ausnehmungen für die Aufnahme der zu behandelnden Objekte aufweist. Durch Drehen des Drehtisches in seinem Gehäuse, welches teilweise in die Vakuumkammer hineinragt, können die Objekte laufend in die Behandlungsposition hinein und wieder herausgebracht werden, so dass ein kontinuierlicher Durchlaufbetrieb ermöglicht wird.

Die Schnelligkeit des Ein- bzw. Ausschleusens hängt davon ab, in welchem zeitlichen Takt die einzelnen Objekte bzw. Objektträger in die Behandlungszone eingeführt werden können und wie lange sie dort zur Behandlung verweilen müssen. Dabei ergibt sich bei manchen Anwendungen ein Dilemma: Häufig müssen nämlich die Objekte vor ihrer Einführung in die Behandlungszone einer Entgasung unterworfen werden. Dies erfordert einen genügend langen vorherigen Aufenthalt dieser Objekte in einem Vakuum. Wenn zur Entgasung eine längere Zeit beansprucht wird als zur Behandlung, können sie bei Durchlaufanlagen also nur verhältnismässig langsam durch die Behandlungskammer hindurchgeführt werden. Anderseits aber will man

um einer rationellen Fertigung wil len einen raschen Durchlauf erzielen. Man hat dieses Problem bisher schon dadurch zu lösen versucht, dass man die zu behandelnden Objekte durch evakuierte Vorkammern hindurchführte, als welche z.B. auch die erwähnten Druckstufen wirksam sind. Oft reichten diese bekannten Massnahmen aber nicht aus, wenn man nicht ein zu langsames Durchlaufen und damit eine unwirtschaftliche Fertigung in Kauf nehmen wollte.

Ein weiteres Problem tritt in Zusammenhang mit den für das Hindurchführen der Objekte durch Vorkammern herkömmlicher Bauweise erforderlichen Bewegungsmechanismen auf. Diese Bewegungsvorrichtungen sollten nämlich betriebssicher sein und möglichst wenig aneinander reibende Flächen aufweisen, weil jede Flächenreibung staubförmigen Abrieb, der z.B.aufzudampfende Schichten verderben kann, und eine vermehrte Gasabgabe und damit eine Beeinträchtigung des Vakuums zur Folge hat. Ausserdem benötigen Betätigungseinrichtungen Bewegungsdurchführungen und bringen damit zusätzlich die Gefahr von Undichtigkeiten mit sich.

Aufgabe der Erfindung ist es nun, eine für Durchlaufbetrieb geeignete Vorrichtung zum Speichern von Objekten unter Vakuum zur Verfügung zu stellen, welche ausser einer um eine Achse drehbaren Aufnahmevorrichtung für die zu speichernden Objekte keine sonstigen Bewegungsmechanismen im Vakuum und Bewegungsdurchführungen durch die Wand der Vakuumkammer erfordert, und die bei gleicher Durchlaufgeschwindigkeit wie bisher, also mit gleichen Arbeitstaktzeiten, einen gegenüber der Zeit des Aufenthaltes in der eigentlichen Behandlungszone verlängerten Aufenthalt der Objekte in der Speicherkammer ermöglicht.

Diese Aufgabe wird mit der erfindungsgemässen Vorrichtung gemäss Patentanspruch 1 gelöst.

Nachfolgend wird die Erfindung an einem Ausführungsbeispiel anhand anliegender Zeichnungen näher erläutert. Es zeigt:

Die Figur 1 einen Schnitt senkrecht zur Drehachse in der Speicherkammer, wobei die zu speichernden (im Beispielsfall plattenförmigen) Objekte wie die Speichen eines Rades radial gehalten werden;

Figur 2 einen Vertikalschnitt parallel zur Achse der Anordnung der Figur 1

Figur 3 einen Schnitt nach BB der Figur 2 durch den Zuführungskanal für die Objekte,

Figur 4 einen Ausschnitt aus einem zur Ebene der Figur 2 senkrechten achsenparallelen Schnitt nach CC und

Fig.5 eine aus einer erfindungsgemässen Speichervorrichtung und einer nachgeschalteten Bedampfungskammer bestehende Anordnung für die Vakuumbedampfung von plättchenförmigen Substraten im taktweisen Durchlaufbetrieb.

Unter Objekten im vorstehenden Sinne können z.B. Substrate, die unter Vakuum beschichtet werden sollen oder aber auch Träger für solche Substrate bzw. für andere unter Vakuum zu behandelnde Gegenstände zusammen mit diesen verstanden werden.

In den Figuren bedeutet 1 die zylindrische evakuierbare Speicherkammer, in welcher um die Achse 2 drehbar eine trommelförmige Aufnahmevorrichtung 3 für eine Mehrzahl von Objekten, nämlich die Träger von zu beschichtenden Substraten, angeordnet ist. Die Halterungen für die einzelnen Objekte sind als Nuten 5 und 6 an der Innenseite des Trommelmantels bzw. an der Nabe 7 der Trommel ausgebildet, wobei in jeder der radial angeordneten Halterungen in Achsrichtung jeweils drei Objekte - in den Figuren mit 4, 4', und 4″ bezeichnet - hintereinander untergebracht werden können. Die Kammer 1 ist über einen Saugstutzen 8 evakuierbar und ihre Stirnseiten 1' und 1″ sind bis auf Ein-bzw. Ausführungsschlitze 9 bzw. 9' für die Objekte geschlossen. Zur Beladung werden diese über eine Druckstufenschleuse durch den Zuführungskanal 10 an den Einführungsschlitz 9 herangebracht und in die jeweils gerade in Einschubposition befindlichen Nuten 5 bzw. 6 der Nabe und der Tromel eingeschoben, wobei, wie gesagt, im vorliegenden Ausführungsbeispiel je drei zu speichernde Objekte, hier also drei Platten oder Träger mit den in sie eingesetzten Platten hintereinander in Achsrichtung Platz finden.

Natürlich könnte die Vorrichtung auch für die Aufnahme von nur zwei oder auch von mehr als drei Objekten hintereinander gebaut werden. Wenn eine Platte bzw. deren Träger in ein Nutenpaar ähnlich wie die Speiche eines Rades eingeschoben ist, wird die Trommel um einen solchen Winkel weitergedreht, dass das nächste Nutenpaar in Einführungsposition gelangt. Sodann kann das nächste Objekt eingebracht und die Trommel wieder weitergedreht werden und so fort bis alle Aufnahmepositionen 4 eines Trommelumfanges besetzt sind.

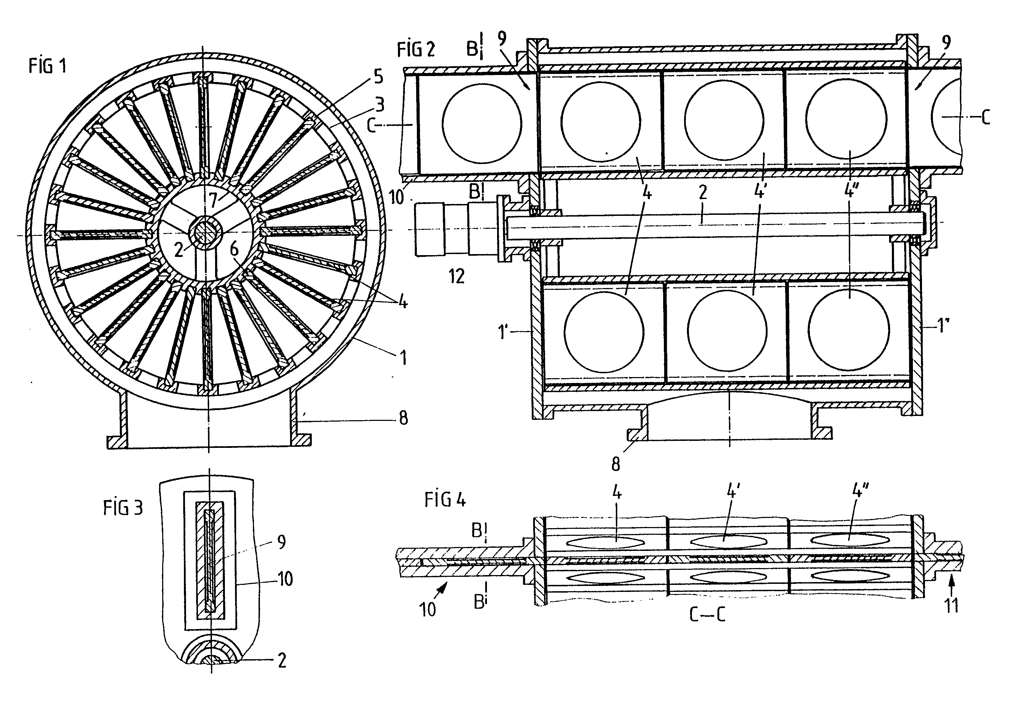

Bezeichnet man die Zeit vom Beginn des Weiterdrehens der Trommel aus einer Winkelposition bis zum Beginn des Weiterdrehens in die nächste als Taktzeit T, dann erfordert eine volle Umdrehung der Trommel im Ausführungsbeispiel wie aus Fig. 1 ersichtlich 24 Taktzeiten.

Würde nun das einzelne Objekt schon nach einer einzigen vollen Umdrehung wieder aus der Speicherkammer herausgenommen werden müssen, dann wäre dessen Aufenthaltszeit im Speicher gleich 24 Taktzeiten. Erfindungsgemäss sind aber in den einzelnen radialen Halterungen eine Mehrzahl -mindestens zwei - Objekte hintereinander unterbringbar und jedesmal, wenn ein bestimmtes Objekt in Position 4 nach einer ersten vollen Umdrehung sich wieder in der mit dem Einführungskanal fluchtenden Stellung befindet wird es durch das Einschieben eines neuen Objektes in achsenparalleler Richtung weiter in die Position für 4' befördert, kann dann erneut eine volle Umdrehung der Aufnahmevorrichtung mitmachen, bis es wiederum mit der Einführungs- und Ausführungsöffnung fluchtet, worauf durch Einbringen eines weiteren Objektes in die gleiche achsenparallele Halterung das zuvor in der Position 4 gewesene Objekt in die Position 4' und das in dieser befindliche Objekt in die Position 4″ vorrückt. Sobald dann nach einer nochmaligen vollen Umdrehung der Aufnahmevorrichtung eines weiteres Objekt in die gleiche dann wieder gerade mit den Ein- und Ausführungsöffnungen fluchtende achsenparallelle Halterung eingeschoben wird, wird das zuvor in der Postion 4″ befindliche Objekt aus dieser heraus in den Ausführungskanal 11 weiterbefördert. Insgesamt beträgt also die Durchlaufzeit jedes einzelnen Objektes durch die Speicherkammer 3 x 24 = 72 Taktzeiten. Auf diese Weise kann die Aufenthaltszeit jedes Objektes in der Speicherkammer auch für Durchlaufbetrieb das Mehrfache der für eine volle Umdrehung benötigten Zeit betragen, bevor es durch den Ausführungskanal wieder ausgestossen und der weiteren Behandlung z.B.in einer nachgeschalteten Beschichtungskammer zugeführt wird. Der vorzugsweise schrittweise Antrieb der Drehachse 2 der Trommel erfolgt mittels des Motors 12.

Die Aufenthaltszeit t jedes einzelnen Objektes in der Speicherkammer beträgt

$$t = n \times N \times T$$

wobei n die Zahl der in jeder Halterung in achsenparalleler Richtung hintereinander unterbringbaren Objekte und N die Zahl in jeder der Positionen 4, 4',4″ usw. auf dem Umfang der Trommel unterbringbaren Objekte bedeutet.

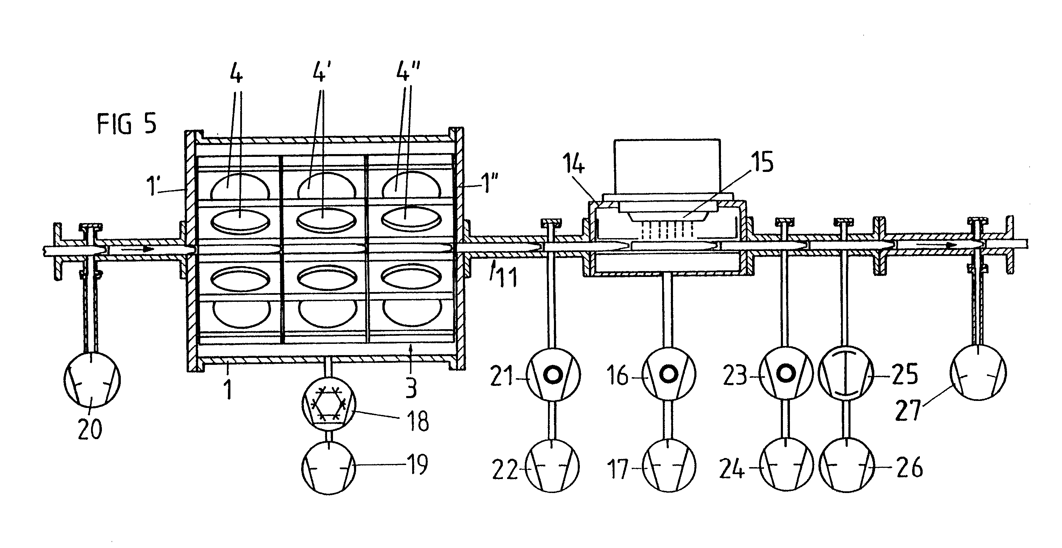

Die Figur 4 lässt erkennen, dass die von den Haltevorrichtungen getragenen Objekte nicht unbedingt Platten sein müssen sondern auch anders, z.B. wie Linsen geformt sein können. Natürlich müssen die Haltevorrichtungen der Form des zu haltenden Objektes angepasst sein, und vorzugsweise besitzen auch die Schleusenkanäle für die Ein- bzw. Ausbringung der Objekte in die bzw. aus der Speicherkammer einen den Objekten bzw. den Objektträgern angepassten Querschnitt und sind mit Dichtungen zur Abdichtung gegenüber den Wänden der Kanäle versehen. Die Dichtungen können als an den Objektträgern befestigte und mit diesen mitbewegte Lippendichtungen ausgebildet und an ihrer in Bewegungsrichtung beim Durchgang durch den Schleusenkanal gesehen vorderen Seite mit konischen Führungsflächen ausgestattet sein; s. hiezu insbesondere Fig. 5.

Wie die Druckstufen und die Schleusenkanäle im einzelnen ausgebildet werden können, ist an sich nicht Gegenstand vorliegender Erfindung; eine nähere beispielsweise Beschreibung findet sich in DE-OS 34 08 946.

Bei der Anordnung der Figur 5 ist der Speicherkammer eine Vakuumbeschichtungskammer 14 nachgeschaltet, in welcher die zu beschichtenden Gegenstände mittels einer Ver dampfungs- oder Zerstäubungseinrichtung 15 beschichtet werden, wobei das Vakuum in der Beschichtungskammer durch die Pumpen 16 und 17 aufrechterhalten wird. Die Speicherkammer 1 wird von dem aus einer Hochvakuumpumpe 18 und einer Vorpumpe 19 bestehenden Pumpstand evakuiert und zur Aufrechterhaltung des nötigen Unterdrucks in den einzelnen Druckstufen der Schleusenkanäle dienen die verschiedenen Pumpen 20 - 27.

Ein und dieselbe Schubvorrichtung, welche bei der Zuführung der Objekte diese im Zuführungskanal vorschiebt und die gleichzeitig auch dazu dient, sie sukzessive in die Trommel 3 einzubringen, kann wie oben schon erwähnt, bei jedem Vorwärtsschritt je ein Objekt aus der gerade in Einschubposition befindlichen Halterung heraus in den mit dem Einschubkanal 10 fluchtenden Ausführungskanal vorschieben. Wie erkennbar, ist auf diese Weise ein taktweiser kontinuierlicher Durchlaufbetrieb möglich, und dabei verbleibt das einzelne Objekt so lange im Speicher, als dem Produkt der Taktzeit und der Zahl der maximal in der Speicherkammer speicherbaren Objekte entspricht. Beträgt die Taktzeit beispielsweise 10 Sekunden - eine Zeitspanne, während welcher etwa in der Behandlungskammer gerade ein Objekt behandelt werden soll - und beträgt die Speicherkapazität wie im Beispielsfall 72 Objekte dann erhält man also eine Aufenthaltszeit jedes einzelnen Objektes im Speicher von 720 Sekunden (= 12 Minuten) und diese Zeit erlaubt bei entsprechendem Vakuum im Speicher gleichzeitig die erforderliche Entgasung; natürlich sind durch geeignete Bemessung der Zahl der Halterungen und der in achsialer Richtung hintereinander in jeder Halterung unterbringbaren Objekte sowie durch die Grösse der Taktzeiten auch andere Speicherzeiten einstellbar.

Aufgrund der durch die erfindungsgemässe Speichervorrichtung ermöglichten, längeren Speicherzeit kann sogar die Speicherkammer selbst ausser für eine Entgasung bei Bedarf auch noch für eine andere Behandlung genutzt werden, z.B. für eine Erwärmung der Platten vor der Beschichtung oder dergleichen . Dafür ist es gegebenenfalls natürlich erforderlich, die Speicherkammer während des Betriebes mittels geeigneter Heizeinrichtungen auf einer höheren Temperatur zu halten. Auch andere Hilfseinrichtungen zur Behandlung der in der Speicherkammer befindlichen Objekte können in dieser Platz finden, z.B. Einrichtungen für eine elektrische Gasentladung, was ebenfalls einer Vorentgasung dienen kann.

## Ansprüche

1. Vorrichtung zum Speichern von Objekten unter Vakuum mit einer in einer evakuierbaren Kammer befindlichen drehbaren Aufnahmevorrichtung mit einer Mehrzahl von um die Drehachse radial angeordneten Halterungen für die Objekte dadurch gekennzeichnet, dass die Aufnahmevorrichtung zur Aufnahme von mindestens je zwei Objekten (4, 4', 4'') in achsenparalleler Richtung hintereinander in jeder Halterung ausgebildet ist.

2. Vorrichtung nach Patentanspruch 1, dadurch gekennzeichnet, dass die Aufnahmevorrichtung als Hohltrommel (3)- mit axialer Nabe (2) ausgebildet ist, und dass zur Halterung für die Objekte die Innenseite des Trommelmantels und die Aussenseite der Nabe achsenparallele Nuten (5,6) aufweisen, in welche die zu speichernden Objekte in achsenparalleler Richtung eingeschoben werden können.

3. Vorrichtung nach Patentanspruch 1, dadurch gekennzeichnet, dass die Speicherkammer (1) zur Drehachse senkrecht stehende Stirnseiten (1', 1'') mit der Form der Objekte angepasster Ein- bzw. Ausführungsöffnung (9, 9') zum Ein- bzw. Ausbringen der Objekte aufweist.

4. Vorrichtung nach Patentanspruch 3, dadurch gekennzeichnet, dass für plattenförmige Objekte die Einführungs- und Ausführungsöffnungen als radiale Schlitze (9, 9')ausgebildet sind.

5. Vorrichtung nach Patentanspruch 1, dadurch gekennzeichnet, dass in der Speicherkammer (1) eine Hilfseinrichtung zur Behandlung der Objekte vorgesehen ist.

6. Vorrichtung nach Patentanspruch 5, dadurch gekennzeichnet, dass die Hilfseinrichtung als Heizvorrichtung ausgebildet ist.

7. Vorrichtung gemäss Patentanspruch 3, dadurch gekennzeichnet, dass den Ein- und Ausführungsöffnungen Druckstufenschleusen (10, 11) zugeordnet sind.

8. Vorrichtung nach Patentanspruch 7, dadurch gekennzeichnet, dass die Druckstufenschleusen (10, 11) für Träger für die zu behandelnden Gegenstände mit einem Schleusenkanal von der Form der Objektträger angepasstem Querschnitt und mit Dichtungen zur Abdichtung zwischen den Trägern und der Wand des Schleusenkanals ausgebildet sind, wobei die Dichtungen an den Trägern befestigt und mit diesen zusammen durch den Schleusenkanal bewegbar sind.

9. Anordnung nach Patentanspruch 8,
dadurch gekennzeichnet,
dass die Dichtungen als an den Trägern befestigte und mit diesen mitbewegte Lippendichtungen ausgebildet sind.

10. Vorrichtung nach Patentanspruch 8,
dadurch gekennzeichnet,
dass die Objekte beim Durchgang durch die Druckstufenschleusen und die Speicherkammer dicht aufeinanderfolgend und einander berührend angeordnet sind, und die Vorwärtsbewegung in solchen Taktschritten erfolgt, dass die Objekte bei jedem Schritt um eine dem Abstand zwischen den einzelnen radial hintereinanderliegenden Positionen (4, 4′, 4″) in den Halterungen entsprechende Strecke weiter vorrücken.

11. Vorrichtung nach Patentanspruch 1,
dadurch gekennzeichnet,
dass der Speicherkammer (1) eine Behandlungskammer (14) für die zu behandelnden Objekte nachgeschaltet ist.

12. Vorrichtung nach Patentanspruch 11,
dadurch gekennzeichnet,
dass die Behandlungskammer (14) als Vakuumbeschichttungskammer ausgebildet ist.

FIG 1

FIG 2

FIG 3

FIG 4

C—C

FIG 5